# EUROPÄISCHE PATENTSCHRIFT

(11) **EP 2 689 191 B1**
(45) Veröffentlichungstag und Bekanntmachung des Hinweises auf die Patenterteilung: **01.02.2017**
(21) Anmeldenummer: 12715868.1
(22) Anmeldetag: 23.03.2012
(51) Int. Cl.: F24C 7/08, H03K 17/96, A47L 15/42, B60K 35/00, D06F 39/00, G02F 1/1333, D06F 58/28

(54) **BEDIENEINRICHTUNG FÜR EIN ELEKTROGERÄT**
OPERATING DEVICE FOR AN ELECTRIC DEVICE
DISPOSITIF DE COMMANDE POUR APPAREIL ÉLECTRIQUE

(30) Priorität: 24.03.2011 DE 102011006021
(43) Veröffentlichungstag der Anmeldung: 29.01.2014
(73) Patentinhaber: E.G.O. Elektro-Gerätebau GmbH, 75038 Oberderdingen (DE)
(72) Erfinder: ZARCONE, Carmelo, 75015 Bretten (DE)
(74) Vertreter: Patentanwälte Ruff, Wilhelm, Beier, Dauster & Partner mbB
(86) Internationale Anmeldenummer: PCT/EP2012/055190
(87) Internationale Veröffentlichungsnummer: WO 2012/127027

(56) Entgegenhaltungen:
- EP-A1- 1 257 057
- EP-A1- 2 045 923

## Beschreibung

### Anwendungsgebiet und Stand der Technik

Die Erfindung betrifft eine Bedieneinrichtung für ein Elektrogerät mit mehreren Anzeigeelementen, mehreren Bedienelementen und einer lichtdurchlässigen oder zumindest teilweise durchsichtigen bzw. transluzenten Bedienfläche, unter der Anzeigeelemente und Bedienelemente angeordnet sind.

Derartige Bedieneinrichtungen sind beispielsweise bekannt aus der WO 2010/094796 A1. Durch Auflegen eines Fingers bzw. durch Darüberziehen eines aufgelegten Fingers ist eine Bedienung des Elektrogerätes möglich. Die Bedienelemente erkennen auf bekannte Art und Weise den jeweiligen Ort des aufgelegten Fingers und somit dessen Bewegung. Die Anzeigeelemente zeigen eine beispielsweise durch Fingerbewegung eingestellte Leistungsstufe an.

Zur Realisierung einer solchen komfortablen und optisch sehr ansprechenden Bedieneinrichtung kann entweder ein vorgenannter Touchscreen verwendet werden, der aber relativ teuer ist und nicht unbedingt unbegrenzt flexibel in geringen Stückzahlen eingesetzt werden kann. Alternativ können sehr flexibel einzelne Bedienelemente und einzelne Anzeigeelemente verwendet werden und beispielsweise auf entsprechenden Bauteilträgern angebracht werden. Dies stellt aber einen größeren Aufwand dar und bedeutet vor allem hohen Montageaufwand.

Eine weitere Bedieneinrichtung nach dem Stand der Technik ist aus der EP 1 257 057 A1 bekannt.

### Aufgabe und Lösung

Der Erfindung liegt die Aufgabe zugrunde, eine eingangs genannte Bedieneinrichtung zu schaffen, mit der Probleme des Standes der Technik vermieden werden können und insbesondere eine günstige und für die Massenfertigung geeignete Möglichkeit geschaffen werden kann, eine vorgenannte Bedieneinrichtung an einem Elektrogerät, insbesondere einem Kochfeld, zu schaffen.

Gelöst wird diese Aufgabe durch eine Bedieneinrichtung mit den Merkmalen des Anspruchs 1. Vorteilhaft sowie bevorzugte Ausgestaltungen der Erfindung sind Gegenstand der weiteren Ansprüche und werden im Folgenden näher erläutert.

Es ist erfindungsgemäß vorgesehen, dass die Bedienelemente flächige kapazitive Sensorelemente sind und zusammen mit den Anzeigeelementen gemeinsame Aufnahmegehäuse aufweisen. So können quasi modular einsetzbare Teile geschaffen werden, die für sich genommen stets gleichartig aufgebaut werden und dann in wählbarer Anzahl und evtl. auch Anordnung beispielsweise auf einem Bauteilträger montiert werden können. Damit können also quasi schematisch immer ähnliche Bedieneinrichtungen aufgebaut werden, die im Detail angepasst sind. Dabei ist ein Sensorelement auf der Oberseite eines Aufnahmegehäuses vorgesehen, und zwar zur Bedienfläche hin bzw. liegt von dem Aufnahmegehäuse angedrückt an einer Unterseite der Bedienfläche an. Die Anzeigeelemente wiederum sind in Durchgangsöffnungen in den Aufnahmegehäusen angeordnet, beispielsweise ein oder zwei Anzeigeelemente pro Durchgangsöffnung. Mindestens zwei Aufnahmegehäuse werden nebeneinander angeordnet bei der Bedieneinrichtung verwendet, vorteilhaft drei oder sogar vier. Sie ähneln sich bzgl. des Aufbaus der Aufnahmegehäuse bzw. können immer nach gleichem, wiederkehrendem Muster bestückt sein mit Anzeigeelementen und Sensorelementen. Ein einziger Unterschied zwischen den nebeneinander angeordneten Aufnahmegehäusen besteht nur darin, dass sie sich bzgl. der Anordnung der Durchgangsöffnungen in dem Aufnahmegehäuse etwas unterscheiden.

Die Ähnlichkeit der Aufnahmegehäuse basiert darauf, dass die Aufnahmegehäuse jeweils Durchgangsöffnungen aufweisen, die entsprechend angeordnet sowie ausgebildet sind. So können besonders vorteilhaft jeweils in der Mitte eine, zwei oder mehr größere längliche Durchgangsöffnungen vorgesehen sein, und an deren kurze Außenkanten angrenzend kleine Durchgangsöffnungen außen, insbesondere drei oder entsprechend viele kleinere Durchgangsöffnungen. Vorteilhaft sind in der Mitte neben den Durchgangsöffnungen auch einige Felder bzw. Bereiche vorgesehen, die geschlossen sind, aber auch wie die Durchgangsöffnungen außen jeweils an eine kleine Durchgangsöffnung angrenzen. Anders ausgedrückt sind erfindungsgemäß jeweils außen an beiden Seite kleine Durchgangsöffnungen vorgesehen, und zwischen je zwei kleinen Durchgangsöffnungen entweder eine große Durchgangsöffnung oder ein entsprechend großes Feld, das geschlossen ist. Dies ist erfindungsgemäß das Kriterium, nach dem sich die Ähnlichkeit bemisst, und die Varianz bzw. die Änderung liegt dann darin, ob bei einem Aufnahmegehäuse zwischen den kleinen Durchgangsöffnungen eine offene große Durchgangsöffnung liegt oder ein geschlossenes Feld, bzw. wie die offenen großen Durchgangsöffnungen und die geschlossenen Felder verteilt sind. In der fertigen Anordnung mehrerer Aufnahmegehäuse nebeneinander bzw. aneinander wechseln sich vorteilhaft in der Mitte offene große Durchgangsöffnungen und geschlossene Felder ab, besonders vorteilhaft sind jeweils offene große Durchgangsöffnungen an den Enden vorgesehen.

Die Anzeigeelemente in den Durchgangsöffnungen werden durch das Aufnahmegehäuse selbst bzw. durch seine Wandungen odgl. gegeneinander abgeschirmt, so dass die jeweiligen Durchgangsöffnungen wie Leuchtfelder, Leuchtsymbole odgl. beleuchtet werden und so durch die Bedienfläche hindurch sichtbar sind. Die Leuchterscheinung hängt dabei unter anderem von der Formgebung der Durchgangsöffnung ab. Dabei ragen die Anzeigeelemente, vorzugsweise in Form von LED, vorteilhaft in die Durchgangsöffnungen hinein, so dass ein Überstrahlen von einer Durchgangsöffnung zur Seite hin bzw. in eine benachbarte Durchgangsöffnung vermieden wird.

In einer ersten grundsätzlichen Ausgestaltung der Erfindung sind die Sensorelemente als separate Teile ausgebildet und getrennt von den Aufnahmegehäusen hergestellt. Sie können beispielsweise aus Flachmaterial, insbesondere Metallblech bzw. Kupferblech, bestehen und durch Erzeugen von Ausnehmungen und Verbiegen bzw. Verformen hergestellt werden. Eine Möglichkeit ist Ausstanzen aus Metallblech und Umbiegen, wie es grundsätzlich für derartige Sensorelemente bekannt ist. Besonders vorteilhaft werden die Sensorelemente dabei auf eine Oberseite der Aufnahmegehäuse aufgesetzt, so dass diese sie trägt, und dann gegen die Unterseite der Bedienfläche angedrückt. Ein Fixieren der Sensorelemente kann entweder durch dieses Andrücken erfolgen oder dadurch, dass die Sensorelemente an zumindest einer Seite, vorzugsweise an zwei gegenüberliegenden Seiten, über das Aufnahmegehäuse überstehen mit seitlichen Überständen. Diese können zur Halterung und/oder elektrischen Kontaktierung dienen. Dabei können die seitlichen Überstände zweimal gebogen sein und dabei bis an eine Unterseite der Aufnahmegehäuse reichen bzw. bis auf einen Bauteilträger, auf dem die Aufnahmegehäuse angeordnet sind. Seitlich abstehende und auf dem Bauteilträger aufliegende Überstände eines Sensorelements können auf einem Kontaktfeld aufliegen und beispielsweise festgelötet sein, alternativ auch mit einer Steckverbindung befestigt und elektrisch kontaktiert werden. Dabei können die Sensorelemente sogar dazu dienen, das Aufnahmegehäuse selbst auf dem Bauteilträger zu befestigen.

In weiterer Ausgestaltung der Erfindung kann vorgesehen sein, dass ein einziges Sensorelement pro Aufnahmegehäuse vorgesehen ist bzw. ein Aufnahmegehäuse nur ein einziges Sensorelement aufweist bzw. bildet.

Weiter kann vorgesehen sein, dass das Sensorelement eine kleinere Fläche als die Oberseite des Aufnahmegehäuses überdeckt bzw. bedeckt. Vor allem sollten über Durchbrüchen mit Anzeigeelementen darin möglichst keine Bereiche des Sensorelements verlaufen, so dass deren Anzeigefunktion nicht beeinträchtigt wird. Es ist auch möglich, dass Ausschnitte in dem Sensorelement von den Anzeigeelementen durchstrahlt werden und durch ihre Formgebung die Leuchterscheinung beeinflussen bzw. durch ihre Formgebung können sie eine Leuchtanzeige bilden.

In Ausgestaltung der Erfindung kann vorgesehen sein, dass das Sensorelement das Aufnahmegehäuse bis auf zwei oder drei Sensorelementausschnitte im Wesentlichen überdeckt und abdeckt. Dabei sollten vor allem zu den Seiten hin jeweils nur Sensorelementausschnitte vorgesehen sein, die von schmalen Stegen begrenzt bzw. eingerahmt werden. Dies bedeutet also, dass zu den Seiten hin Durchgangsöffnungen des Aufnahmegehäuses mit Anzeigeelementen darin vorgesehen sind und eine Anzeigefunktion bilden.

Ein Aufnahmegehäuse kann mehrere Durchgangsöffnungen in bzw. zwischen einem gitterartigen Rahmen aufweisen, so dass ein Aufnahmegehäuse selbst im Wesentlichen gitterartig bzw. rahmenartig ausgebildet ist oder in Felder unterteilt ist. Vorteilhaft weist ein Aufnahmegehäuse dabei drei parallele Reihen von Durchgangsöffnungen auf in einer Richtung seiner Erstreckung, vorteilhaft in der kürzeren Richtung. Dabei sind links und rechts außen zwei Reihen von identischen Durchgangsöffnungen vorgesehen, die besonders vorteilhaft jeweils nur ein einziges Anzeigeelement enthalten und in etwa quadratisch sind. Dazwischen kann eine mittlere Reihe von Durchgangsöffnungen vorgesehen sein, die anders ausgebildet sind bzw. erheblich größer oder breiter sind. Hier können vorteilhaft mehr bzw. zwei Anzeigeelemente vorgesehen sein zur gleichmäßigen Ausleuchtung, vorteilhaft mit einer Leuchtstärke, die derjenigen in den kleinen Durchgangsöffnungen entspricht.

In weiterer Ausgestaltung der Erfindung können die Durchgangsöffnungen, in denen Anzeigeelemente enthalten sind, lichtstreuendes Material bzw. eine Diffusorfunktion aufweisen. Dazu können sie im Wesentlichen mit Diffusor-Material gefüllt sein oder es insbesondere an ihrer Oberseite aufweisen, beispielsweise nach Art einer Scheibe oder Füllung.

In Ausgestaltung der Erfindung können drei aneinander anliegende Aufnahmegehäuse vorgesehen sein, die jeweils darüber angebrachte, separate Sensorelemente aufweisen, besonders vorteilhaft ein Sensorelement pro Aufnahmegehäuse. An beiden Enden der mittleren Reihe sind die Durchgangsöffnungen nicht von einem Sensorelement überdeckt, während die beiden äußeren Sensorelemente mit einem Sensorelementüberstand in Erstreckungsrichtung dieser mittleren Reihe über sie überstehen und vorteilhaft an der Unterseite der Bedienfläche anliegen können. Durch diese quasi abwechselnd angeordneten Bereiche von Fläche eines Sensorelements und freier Durchgangsöffnung ist so die Sensorelementfunktion gewährleistet, beispielsweise nach Art eines sogenannten Sliders durch mehrere kapazitive Sensorelemente entlang einer Linie. In den Bereichen dazwischen ohne Sensorelement mit Durchgangsöffnung sind Anzeigeelemente vorgesehen, die entweder den Slider für eine Bedienperson anzeigen oder aber, wie nachfolgend noch näher erläutert wird, ein Symbol bzw. einen Wert einer Anzeige, der mit der Bedieneinrichtung eingestellt worden ist, darstellen.

Hier ist es vorteilhaft möglich, dass die Sensorelemente eben manche der Durchgangsöffnungen der mittleren Reihe überdecken, insbesondere nämlich jede zweite Durchgangsöffnung. Die Durchgangsöffnungen der beiden äußeren Reihen links und rechts von der mittleren Reihe bleiben stets im Wesentlichen frei, so dass hier Anzeigeelemente in den Durchgangsöffnungen angeordnet werden können. Gleichzeitig kann hier zugegebenermaßen keine Bedienelement-Funktion ausgeübt werden. Die Sensorelemente verlaufen mit schmalen Stegen zwischen den Durchgangsöffnungen der äußeren Reihen nach außen zur elektrischen Kontaktierung bzw. mechanischen Befestigung.

Die genannten Durchgangsöffnungen der mittleren Reihe können vorteilhaft deutlich breiter sein als die Durchgangsöffnungen der äußeren beiden Reihen. Der Unterschied kann den Faktor 2 bis 5 betragen, vorteilhaft 2 bis 3. In Längsrichtung der Anordnung der drei Aufnahmegehäuse, also quasi praktisch in Bedienungsrichtung des Sliders, können die Durchgangsöffnungen aller Reihen gleich lang sein. Mit einer derart ausgebildeten Bedieneinrichtung können durch die länglichen mittleren Durchgangsöffnungen und die kurzen äußeren Durchgangsöffnungen Sieben-Segment-Anzeigen dargestellt bzw. nachgebildet werden, insbesondere mit Durchlauf-Funktion in Bedienungsrichtung des Sliders bzw. Längsrichtung der drei Aufnahmegehäuse aneinander.

In einer grundsätzlich anderen Ausgestaltung der Erfindung bestehen die Aufnahmegehäuse aus elektrisch leitfähigem Material, beispielsweise hartem oder weichem Kunststoff mit entsprechenden Zusätzen. Sie liegen mit ihrer Oberseite an der Unterseite der Bedienfläche an, wobei wiederum mehrere Aufnahmegehäuse aneinander anliegen. Sie können jeweils durch eine Isolierung elektrisch voneinander getrennt sein. Die Oberseiten der elektrisch leitfähigen Aufnahmegehäuse bilden dabei die eingangs genannten Sensorelemente bzw. Bedienelemente.

Eine vorgenannte Isolierung kann beispielsweise eine dauerhaft auf eine Gehäuseaußenwand aufgebrachte Isolierschicht sein, beispielsweise auch in Form einer Klebeschicht bzw. eines Klebestreifens. Alternativ kann es ein Isolierlack sein oder in einem Mehrkomponenten-Spritzgießverfahren eine angespritzte Isolierschicht. Auch bei dieser zweiten grundsätzlichen Ausgestaltung der Erfindung kann ein Aufnahmegehäuse grundsätzlich ähnlich ausgestaltet sein wie zuvor beschrieben, also mehrere Durchgangsöffnungen aufweisen und somit eine Art Gitterform bzw. Rahmenform. Es können wiederum mehrere, vorzugsweise drei, parallele Reihen von Durchgangsöffnungen vorgesehen sein. Bei drei Reihen von Durchgangsöffnungen weisen zwei äußere Reihen identische Durchgangsöffnungen auf, beispielsweise mit in etwa quadratischer Form. Eine mittlere Reihe von Durchgangsöffnungen befindet sich dazwischen, wobei eben in den jeweiligen Durchgangsöffnungen mindestens ein Anzeigeelement angeordnet ist.

In dem vorbeschriebenen Fall können vorteilhaft die Durchgangsöffnungen der mittleren Reihe deutlich breiter sein als diejenigen der äußeren beiden Reihen. Sie können beispielsweise zweimal bis fünfmal so breit sein und zwei oder drei Anzeigeelemente aufweisen für eine gleichmäßige Ausleuchtung, wobei vorzugsweise die Ausleuchtung auf die Fläche bezogen derjenigen in den kleineren Durchgangsöffnungen entspricht. In Verlaufsrichtung der drei Reihen sind vorteilhaft sämtliche Durchgangsöffnungen gleich lang.

Allgemein können bei der Erfindung die Aufnahmegehäuse parallel zur Bedienfläche verlaufen und flach ausgebildet sein. Vorteilhaft weisen sie in Draufsicht Rechteckform auf mit einer Breite, die eineinhalbmal bis dreimal so groß ist wie ihre Länge. Dabei liegen die Aufnahmegehäuse mit ihren längeren Seiten aneinander an, so dass bei mehreren aneinander anliegenden Aufnahmegehäusen eine Anordnung vorliegt, die insgesamt in dieser Richtung länger ist als ihre Breite.

Vorteilhaft sind die Aufnahmegehäuse auf Bauteilträger aufgesetzt, beispielsweise Leiterplatten. Die Bauteilträger tragen auch die Anzeigeelemente und kontaktieren diese elektrisch, beispielsweise LED oder SMD-LED. Auch die Sensorelemente sind an den Bauteilträger geführt und dort elektrisch kontaktiert. Dabei können beispielsweise seitlich über die Aufnahmegehäuse überstehende Sensorelementüberstände verwendet werden, wie sie vorstehend bereits genannt worden sind. Sie können an entsprechende Kontaktfelder angelegt und festgelötet sein, alternativ in Bohrungen oder in Steckeraufnahmen eingesteckt sein.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Schrägansicht einer Bedieneinrichtung mit Bedienelementen und Anzeigeelementen an Aufnahmegehäusen,
- Fig. 2: eine Draufsicht auf die Bedieneinrichtung aus Fig. 1 mit nach rechts gezogenen Bedienelementen in Form von flachen Sensorelementen, woraus die gitterartige Ausbildung bzw. feldartige Unterteilung der Bedieneinrichtung bzw. der Aufnahmegehäuse ersichtlich ist,
- Fig. 3: ein Schnitt durch die Bedieneinrichtung aus Fig. 1 im Einbauzustand in ein Elektrogerät,
- Fig. 4: ein einzelnes mittleres Aufnahmegehäuse entsprechend der Bedieneinrichtung aus Fig. 1 in Schrägansicht,
- Fig. 5: das Aufnahmegehäuse aus Fig. 4 mit aufgelegtem mittlerem Sensorelement entsprechend Fig. 2,
- Fig. 6: eine Schrägansicht des unteren Sensorelements aus Fig. 2,
- Fig. 7: eine Schrägansicht ähnlich Fig. 5 des unteren Aufnahmegehäuses mit aufgelegtem mittlerem Sensorelement entsprechend Fig. 6,
- Fig.8: eine Abwandlung der Bedieneinrichtung ähnlich Fig. 1 mit drei Aufnahmegehäusen aus elektrisch leitfähigem Kunststoff, die mittels Isolierungen elektrisch voneinander getrennt sind,
- Fig. 9: einzelne Aufnahmegehäuse ähnlich Fig. 8 aus elektrisch leitfähigem Schaumstoffmaterial, die beim Zusammensetzen noch elektrisch gegeneinander isoliert werden müssen und
- Fig. 10: ein Ablauf für ein Bedienverfahren, bei dem mit einem Finger über die Bedieneinrichtung gewischt wird und sich dabei, wie jeweils rechts daneben dargestellt ist, die Anzeige entsprechend ändert.

### Detaillierte Beschreibung der Ausführungsbeispiele

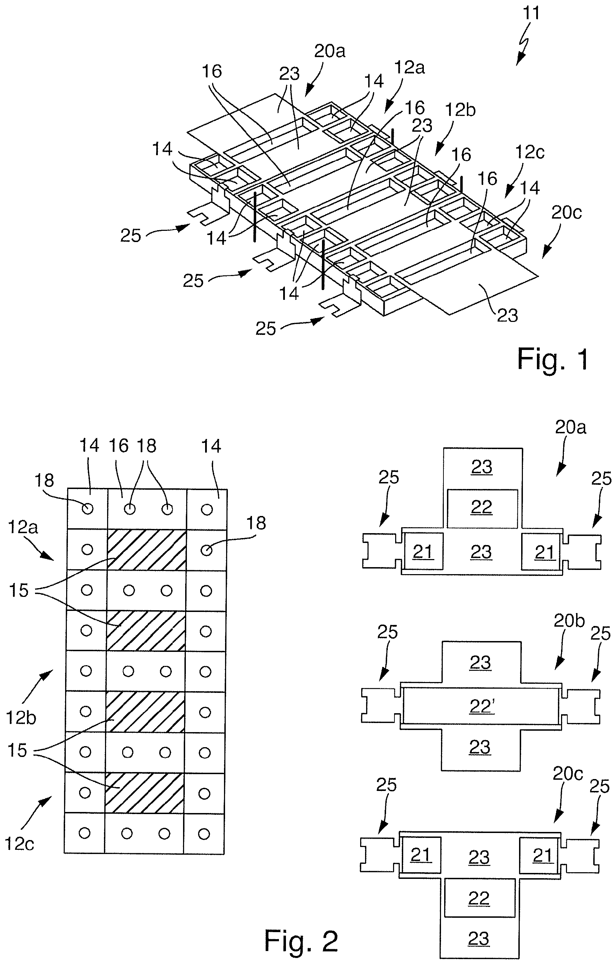

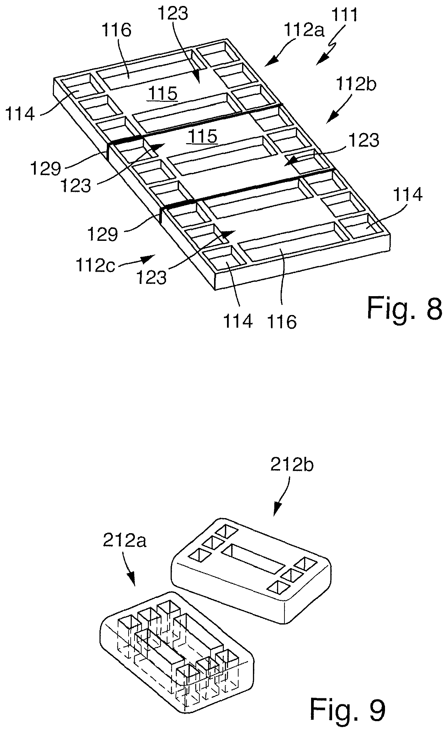

In Fig. 1 ist eine erfindungsgemäße Bedieneinrichtung 11 in Schrägansicht dargestellt, welche aus drei Aufnahmegehäusen 12a, 12,b und 12c besteht bzw. solche aufweist. Diese bestehen aus elektrisch isolierendem Kunststoff und sind miteinander verbunden um eine Baueinheit zu bilden, beispielsweise durch Verkleben im Fall von Kunststoffteilen. Durch die seitlichen dicken Linien sind die Trennlinien zwischen den einzelnen Aufnahmegehäusen dargestellt. Die Aufnahmegehäuse 12 weisen jeweils, wie aus den nachfolgenden Figuren auch noch deutlicher wird, insbesondere aus der ähnlich ausgebildeten Fig. 8, am linken und am Rand, was dem eingangs beschriebenen vorderen und hinteren Ende entspricht, jeweils kleine Durchgangsöffnungen 14 auf, die in etwa quadratisch ausgebildet sind, und zwar jeweils drei Durchgangsöffnungen 14 pro Seite eines Aufnahmegehäuses 12. Weitere Öffnungen sind an den Aufnahmegehäusen 12 zwischen den Durchgangsöffnungen 14 in einem Mittelbereich vorgesehen. Beim Aufnahmegehäuse 12b ist das eine mittlere längliche Durchgangsöffnung 16. Sie liegt zwischen den beiden mittleren Durchgangsöffnungen 14, während das Aufnahmegehäuse 12b zwischen den anderen Durchgangsöffnungen 14 einen massiven Bereich 15 aufweist.

Die Aufnahmegehäuse 12a und 12c weisen jeweils zwischen den mittleren Durchgangsöffnungen 14 keine längliche Durchgangsöffnungen 16 auf, sondern massive Bereiche 15. Zwischen den oberen kleinen Durchgangsöffnungen 14 und den unteren kleinen Durchgangsöffnungen 14 dagegen sind zwei längliche Durchgangsöffnungen 16 vorgesehen, die etwa zwei- bis dreimal so lang sind wie die kleinen Durchgangsöffnungen 14 und dieselbe Breite aufweisen.

In der Draufsicht in Fig. 2 links ist die feldartige bzw. gitterartige Aufteilung der Aufnahmegehäuse 12 gut zu sehen. Des Weiteren sind dort LED 18 symbolisch dargestellt, mit den als Anzeigeelemente die Anzeige der Bedieneinrichtung realisiert ist. In jeder kleinen Durchgangsöffnung 14 ist eine LED 18 angeordnet, in den länglichen Durchgangsöffnungen 16 sind je zwei LED 18 angeordnet. Diese leuchten sie gleichmäßig aus, so dass nach oben hin im wesentlichen rechteckige Leuchtfelder zu sehen sind.

In Fig. 2 ist nach rechts neben die Aufnahmegehäuse 12a-c gezogen in Draufsicht jeweils das zugehörige Sensorelement 20a-c dargestellt, wie sie auch bereits in der Fig. 1 enthalten sind. Ein oberes Sensorelement 20a besteht, wie die anderen Sensorelemente 20b und 20c auch, aus dünnem Metallblech, beispielsweise Kupferblech. Es weist zwei kleine Durchbrüche 21 auf, welche den vorgenanten Sensorelementausschnitten entsprechen und nachher über den kleinen Durchgangsöffnungen 14 liegen. Des Weiteren weist es im Mittelbereich einen länglichen Durchbruch 22 auf, der über einer länglichen Durchgangsöffnung 16 liegt, was auch aus Fig. 1 zu erkennen ist. Im Wesentlichen bildet das Sensorelement 20 also zwei Sensorflächen 23, die elektrisch miteinander verbunden sind durch die einteilige Herstellung. Die schmalen Bereiche um die kleinen Durchbrüche 21 dienen nur zur elektrischen Kontaktierung zur Seite hin, was noch genauer beschrieben wird. Außerhalb der kleinen Durchbrüche 21 weist das Sensorelement 20a jeweils einen Haltefuß 25 auf, der entsprechend Fig. 1 nach unten abgebogen ist und, wie nachfolgend noch näher erläutert wird, sowohl zur elektrischen Kontaktierung als auch möglicherweise zur Befestigung dient.

Das Sensorelement 20c ist gleich ausgebildet wie das Sensorelement 20a, nur eben um 180° in Zeichenebene nach unten gedreht.

Ein weiteres Sensorelement 20b ist etwas anders ausgebildet und weist nur einen einzigen länglichen Durchbruch 22' auf, der quasi dadurch erzeugt worden ist, dass beim Sensorelement 20a der längliche Durchbruch 22 genau zwischen die beiden kleinen Durchbrüche 21 geschoben worden ist. Die obere Sensorfläche 23 ist dafür auf die untere Seite des länglichen Durchbruchs 22' gewandert, so dass sich eine längssymmetrische Ausbildung ergibt. Dies bedeutet, dass der längliche Durchbruch 22' durchgängig über in einer Reihe angeordneten kleinen Durchgangsöffnungen 14 mit einer länglichen Durchgangsöffnungen 16 dazwischen erstreckt und die somit in Reihe liegenden vier LED 18 darunter freigibt. Auch beim Sensorelement 20b sind außerhalb des Durchbruchs 22' Haltefüße 25 vorgesehen.

Aus der Zusammenschau der Fig. 1 mit der Fig. 2 links ist auch zu ersehen, dass mit der erfindungsgemäßen Bedieneinrichtung 11 eine Art Matrixanzeige geschaffen werden kann ähnlich einer Sieben-Segment-Anzeige, nur mit deutlich feinerer Unterteilung. Es sind hier nämlich 23 Segmente gegeben in Form der Durchgangsöffnungen 14 und 16 mit insgesamt 28 LED 18, und jede Durchgangsöffnung 14 und 16 bzw. jedes Feld kann unabhängig von den anderen angesteuert werden. Damit können, wie nachfolgend noch erläutert wird, nicht nur entsprechend einer Sieben-Segment-Anzeige Zahlen oder Buchstaben dargestellt werden, sondern es ist sogar eine Art Laufschrift möglich, was nachfolgend noch näher erläutert wird.

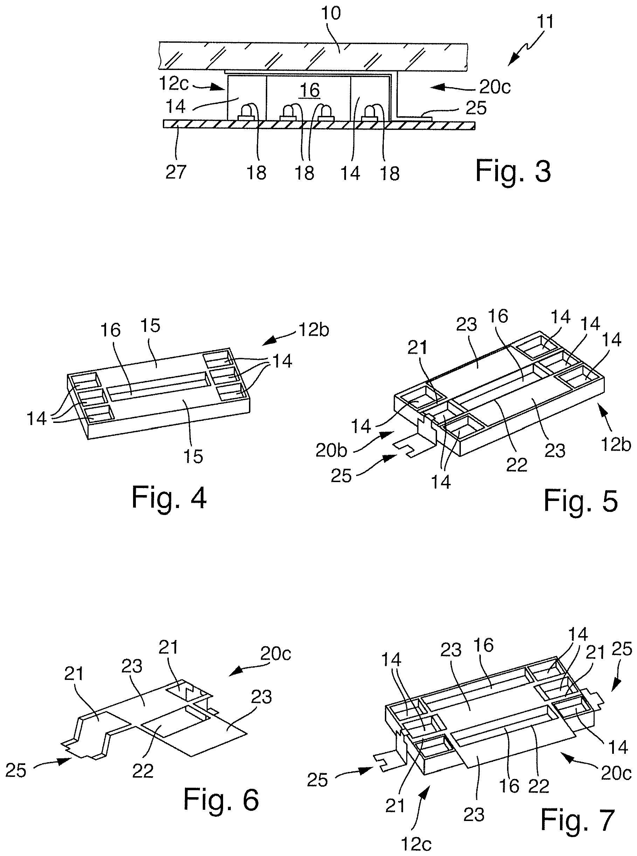

In Fig. 3 ist ein Schnitt durch eine erfindungsgemäße Bedieneinrichtung 11 in einem Elektrogerät gezeigt, beispielsweise mit einer Glaskeramikplatte 10 als Kochfeld und als Bedienfeld. Dabei sind auf einer Leiterplatte 27 die LED 18 in den kleinen Durchgangsöffnungen 14 bzw. der länglichen Durchgangsöffnung 16 angeordnet. Zwar verläuft über dem entsprechenden Aufnahmegehäuse 12 ein Sensorelement 20, allerdings direkt über den Durchgangsöffnungen 14 bzw. 16 und somit auch den LED 18 mit Ausschnitten, beispielsweise beim Sensorelement 20b dem länglichen Durchbruch 22'. Somit beeinträchtigt das Sensorelement 20 die Leuchtwirkung der LED 18 nach oben nicht oder nur ganz unwesentlich am Rand.

Die Anordnung in Fig. 3 kann so sein, dass die Bedieneinrichtung 11 mit dem Sensorelement 20b an der Unterseite der Glaskeramik-Platte 10 anliegt. Die Aufnahmegehäuse 12 können dabei entweder auf der Leiterplatte 27 festgeklebt sein oder aber durch sonstige Haltemittel gehalten werden. Eine weitere Möglichkeit ist es, sie mittels der Sensorelemente 20 zu befestigen. Dazu ist nämlich ein Haltefuß 25 des Sensorelements 20b auf die Oberseite der Leiterplatte 27 geführt und kann dort beispielsweise auf einem Kontaktfeld festgelötet sein als elektrische Kontaktierung sowie als mechanische Halterung.

Aus der Darstellung in Fig. 1 ist auch noch zu ersehen, dass die Bedieneinrichtung 11 sechs Sensorflächen 23 in einer Linie aufweist, also zwei Sensorflächen 23 pro Aufnahmegehäuse 12. Benachbarte Sensorflächen weisen zwischen sich eine freie Fläche auf, die etwa deren Größe hat und unter der eine längliche Durchgangsöffnung 16 liegt. Jeweils Sensorflächen 23 sind auch elektrisch wie eines und bilden, wie aus Fig. 3 zu ersehen ist, jeweils ein kapazitives Sensorelement.

In Fig. 4 ist ein einzelnes Aufnahmegehäuse 12b dargestellt, um dessen Ausbildung mit den kleinen Durchgangsöffnungen 14 und der länglichen Durchgangsöffnungen 16 noch einmal zu veranschaulichen. In Fig. 5 ist das Aufnahmegehäuse 12b aus Fig. 1 mit einem aufgesetzten Sensorelement 20b versehen dargestellt. Aus dem direkten Vergleich ist zu ersehen, dass die Sensorflächen 23 des Sensorelements 20b über den massiven Bereichen 15 des Aufnahmegehäuses 12b oberhalb und unterhalb der länglichen Durchgangsöffnungen 16 liegen. Die mittleren kleinen Durchgangsöffnungen 14 sind aufgrund der Länge des länglichen Durchbruchs 22' im Sensorelement 20b ebenfalls nach oben offen. Die kleinen Durchgangsöffnungen 14 in den Ecken sind ohnehin von dem Sensorelement 20b weder überdeckt noch umrandet.

In Fig. 6 ist, wie zuvor schon angedeutet, noch einmal ein Sensorelement 20c in Schrägdarstellung dargestellt. Auch hier ist zu erkennen, wie dieses Sensorelement 20c durch Ausstanzen und Umformen bzw. Umbiegen aus einem einzigen Blechteil hergestellt worden ist, wobei eben hauptsächlich die beiden Sensorflächen 23 bestehen bleiben, welche dann als kapazitives Sensorelement mit zwei verteilt angeordneten Flächen wirkt. Ebenso sind die kleinen Durchgangsöffnungen 14 und die längliche Durchgangsöffnung 16 zu erkennen, die die LED 18 nach oben durchstrahlen lassen.

In Fig. 7 ist dargestellt, wie dieses Sensorelement 20c auf ein Aufnahmegehäuse 12c aufgesetzt ist. Wie zuvor genannt, befindet sich die obere Sensorfläche 23 oberhalb des massiven Bereichs des Aufnahmegehäuses 12c, welches entsprechend Fig. 2 ohnehin keine LED enthält. Die untere längliche Durchgangsöffnung 16 liegt unterhalb des länglichen Durchbruchs 22 zum Durchstrahlen, ähnlich liegen die mittleren kleinen Durchgangsöffnungen 14 unter den kleinen Durchbrüchen 21 zum Durchstrahlen. Die untere Sensorfläche 23 ragt nach unten über das Aufnahmegehäuse 12c über, siehe auch Fig. 1.

In Fig. 8 ist eine alternative Bedieneinrichtung 111 dargestellt, welche auch drei Aufnahmegehäuse 112a, 112b und 112c aufweist. Diese sind von der Geometrie her auch ausgebildet wie in den Fig. 1, 2, 4, 5 und 7 dargestellt. Der Unterschied besteht jedoch darin, dass sie aus relativ hartem elektrisch leitfähigem Kunststoff ausgebildet sind und zwar auch miteinander verbunden bzw. verklebt sind. Eventuell kann diese elektrische Leitfähigkeit auch durch eine entsprechende elektrisch leitfähige Beschichtung erreicht werden, die vorteilhaft zumindest die Oberseiten bedeckt und besonders vorteilhaft auch nach unten reicht zur elektrischen Kontaktierung. Zwischen den einzelnen Aufnahmegehäusen 112a bis 112c befinden sich jedoch zwei Isolierungen 129, beispielsweise auch als isolierender doppelseitiger Klebestreifen oder Klebstoff. Da die Aufnahmegehäuse 112a-c selbst elektrisch leitfähig sind, bilden sie ebenso kapazitive Sensorelemente, insbesondere mit den massiven Bereichen 115, die dann entsprechend Fig. 3 an der Unterseite der Glaskeramikplatte direkt anliegen würden, was für die Funktion als kapazitives Sensorelement für einen Berührungsschalter bekanntermaßen ausschlaggebend ist, siehe hierfür beispielsweise die EP 859 467 A. Da hier jedoch keine überstehenden Sensorflächen entsprechend Fig. 1 oder 7 dargestellt sind, weist die Bedieneinrichtung 111 der Fig. 8 nur vier Sensorflächen 123 auf, die eben von den massiven Bereichen 115 gebildet werden. Eventuell können jedoch noch flügelartige Fortsätze entsprechend der äußersten Sensorflächen 23 gemäß Fig. 1 an den Aufnahmegehäuse 112a und c vorgesehen werden.

Es ist aus Fig. 8 auch zu erkennen, wie im übrigen auch entsprechend der anderen Figuren, dass zwei unterschiedliche Arten von Aufnahmegehäusen bereitgestellt werden müssen, auch ohne separate Sensorelemente aus Metallblech odgl..

In Fig. 9 ist ein weiteres Beispiel für Aufnahmegehäuse 212a und 212b dargestellt. Diese sind grundsätzlich ähnlich wie in Fig. 8 ausgebildet, bestehen jedoch nicht aus hartem Kunststoffmaterial, sondern aus weichem bzw. elastischem Kunststoffmaterial, beispielsweise Schaumstoff. Dies wird hier dadurch dargestellt, dass die Ecken und Kanten etwas abgerundeter ausgebildet sind. Ansonsten können diese drei Aufnahmegehäuse 212a und 212b entsprechend Fig. 8 ausgebildet sein und zusammengesetzt werden.

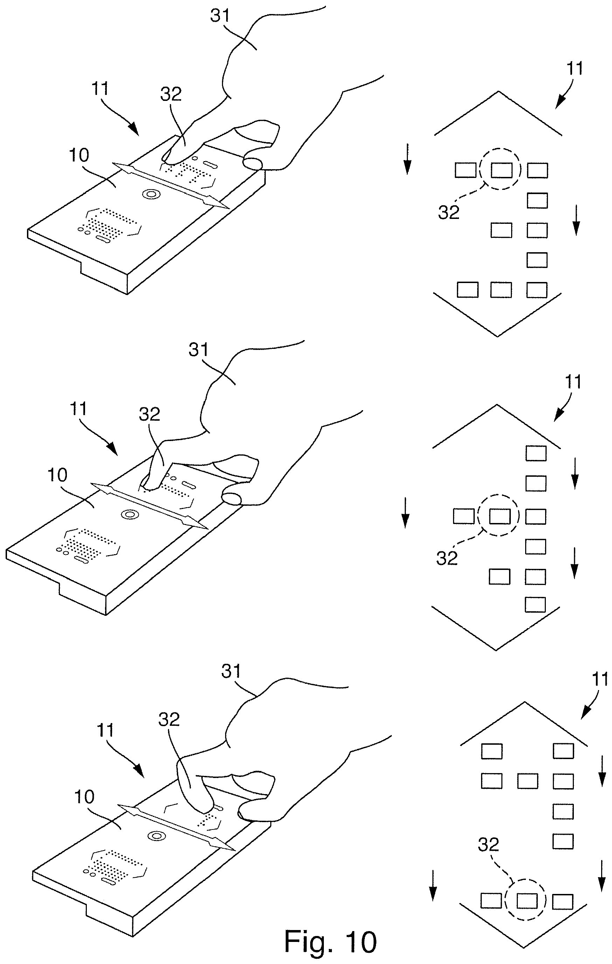

In Fig. 10 ist dargestellt, wie eine Bedieneinrichtung 11 gemäß Fig. 1 im eingebauten Zustand unter einer Glaskeramikplatte 10 entsprechend Fig. 3 odgl. bedient werden kann. Eine Hand 31 mit einem Finger 32 berührt die Bedieneinrichtung 11 oberhalb der Anzeige durch die LED 18, welche, wie oben rechts dargestellt ist, gerade eine "3" darstellt. Diese "3" ist dabei durch kurze sowie längliche Leuchtsymbole entsprechend der kleinen Durchgangsöffnungen 14 und länglichen Durchgangsöffnungen 16, in denen sich die LED 18 befinden, gebildet. Es ist zu erkennen, dass rechts fünf kleine Durchgangsöffnungen 14 übereinander beleuchtet sind, also sowohl nach oben als auch nach unten noch mehr Durchgangsöffnungen bzw. Leuchtsymbole erzeugt werden können. Ein gestrichelt dargestellter Kreis markiert die Aufsetzstelle des Fingers 32, der sich entsprechend dem links dargestellten dünnen Pfeil nach unten bewegt. Dies hat eine Bewegung des Zahlensymbols "3" gemäß dem rechts dargestellten dicken Pfeil zur Folge.

In der mittleren Darstellung links ist zu erkennen, wie der Finger 32 in einer ziehenden Bewegung nach unten gezogen wird und dabei sozusagen die "3" nach unten wandert, wobei gleichzeitig von oben bereits als nächstes Zahlensymbol die "4" in Bild kommt, was ebenfalls durch den rechten dicken Pfeil dargestellt ist. Es kann also sowohl eine sogenannte Slider-Bedienbewegung des Fingers 32 erreicht werden durch die sechs in Reihe angeordneten Sensorflächen 23 der Sensorelemente 20, welche eben wie ein eingangs genannter bekannter Slider angeordnet und ausgebildet sind. Des Weiteren kann entsprechend dieser ziehenden Bedienbewegung auch das dargestellte Zahlensymbol bewegt werden mit einer einfach ausgebildeten Bedieneinrichtung samt Anzeige.

In Fig. 10 unten ist links dargestellt, wie der Finger 32 am unteren Ende über der Bedieneinrichtung 11 angelangt ist. In der Funktionsdarstellung rechts daneben ist dies auch noch einmal dargestellt. Des Weiteren ist zu ersehen, dass das vorherige Zahlensymbol "3" nahezu ganz aus dem Blickfeld bzw. von der Anzeige nach unten verschwunden ist, während das nächste Zahlensymbol "4" fast vollständig erschienen ist.

Beim Bedienverfahren kann vorgesehen sein, dass dieses nächste Zahlensymbol "4" automatisch zentral in die Anzeige rutscht, auch wenn die Fingerbewegung nicht ganz so weit reicht wie benötigt. Diese "4" wird dann eben sowohl dargestellt als auch über die Bedieneinrichtung 11 an eine Steuerung für eine entsprechende Funktionseinheit des Elektrogeräts, beispielsweise eine Kochstelle eines Elektrokochfeldes, gegeben.

## Patentansprüche

1. Bedieneinrichtung (11, 111) für ein Elektrogerät mit mehreren Anzeigeelementen (18), mehreren Bedienelementen und einer lichtdurchlässigen Bedienfläche (10), unter der die Anzeigeelemente und die Bedienelemente angeordnet sind für eine Bedienung durch Auflegen eines Fingers und/oder durch Darüberziehen eines aufgelegten Fingers, wobei die Bedienelemente flächige kapazitive Sensorelemente (20, 123) sind und zusammen mit den Anzeigeelementen (18) gemeinsame Aufnahmegehäuse (12, 112, 212) aufweisen, an deren Oberseiten zur Bedienfläche hin die Sensorelemente vorgesehen sind, wobei die Anzeigeelemente in Durchgangsöffnungen (14, 16, 114, 116) in den Aufnahmegehäusen angeordnet sind,
**dadurch gekennzeichnet, dass** die Bedieneinrichtung (11, 111) mindestens zwei verschiedene nebeneinander angeordnete Aufnahmegehäuse (12, 112, 212) aufweist, die aus einer Gruppe von zwei ähnlichen Aufnahmegehäusen ausgewählt sind, wobei die Gruppe von ähnlichen Aufnahmegehäusen dadurch definiert ist, dass jeweils außen an beiden Seiten der Aufnahmegehäuse (12, 112, 212) kleine Durchgangsöffnungen (14, 114) vorgesehen sind, und zwischen je zwei kleinen Durchgangsöffnungen (14, 114) entweder eine große Durchgangsöffnung (16, 116) oder ein entsprechend großes Feld (15, 115) vorgesehen ist, das geschlossen ist,
wobei ein Aufnahmegehäuse (12, 112, 212) mehrere Durchgangsöffnungen (14, 16, 114, 116) in bzw. zwischen einem gitterartigen Rahmen aufweist.

2. Bedieneinrichtung nach Anspruch 1, **dadurch gekennzeichnet, dass** die Sensorelemente (20) von den Aufnahmegehäusen (12) separate Teile sind und aus Flachmaterial, insbesondere Metallblech, hergestellt sind durch Erzeugen von Ausnehmungen (21, 22) und Verbiegen bzw. Verformen, wobei vorzugsweise die Sensorelemente auf eine Oberseite der Aufnahmegehäuse aufgesetzt sind und mittels dieser gegen die Unterseite der Bedienfläche (10) angedrückt werden.

3. Bedieneinrichtung nach Anspruch 1 oder 2, **dadurch gekennzeichnet, dass** die Sensorelemente (20) an zumindest einer Seite, vorzugsweise an zwei gegenüberliegenden Seiten, über ein Aufnahmegehäuse (12) überstehen mit seitlichen Überständen (25) zur Halterung und/oder elektrischen Kontaktierung, wobei vorzugsweise die seitlichen Überstände (25) zweimal gebogen sind bis an eine Unterseite der Aufnahmegehäuse bzw. an einen Bauteilträger (27), auf dem die Aufnahmegehäuse angeordnet sind, und seitlich davon abstehen.

4. Bedieneinrichtung nach einem der vorhergehenden Ansprüche, **dadurch gekennzeichnet, dass** ein einziges Sensorelement (20, 123) pro Aufnahmegehäuse (12, 112) vorgesehen ist, wobei insbesondere das Sensorelement eine kleinere Fläche als die Oberseite des Aufnahmegehäuses überdeckt.

5. Bedieneinrichtung nach Anspruch 4, **dadurch gekennzeichnet, dass** das Sensorelement (20) das Aufnahmegehäuse (12) bis auf zwei oder drei Sensorelementausschnitte (21) bzw. Durchbrüche im Wesentlichen überdeckt und abdeckt, wobei vorzugsweise das Sensorelement (20) zu den Seiten hin jeweils nur Sensorelementausschnitte (21) bzw. Durchbrüche aufweist, die von schmalen Stegen begrenzt bzw. eingerahmt sind.

6. Bedieneinrichtung nach einem der vorhergehenden Ansprüche, **dadurch gekennzeichnet, dass** drei parallele Reihen von Durchgangsöffnungen (14, 16, 114, 116) vorgesehen sind und dabei zwei äußere Reihen identische Durchgangsöffnungen (14, 114) aufweisen mit einer mittleren Reihe von Durchgangsöffnungen (16, 116) dazwischen.

7. Bedieneinrichtung nach Anspruch 6, **gekennzeichnet durch** drei aneinander anliegende Aufnahmegehäuse (12) mit darüber angebrachten, separaten Sensorelementen (20), wobei an beiden Enden der mittleren Reihe die Durchgangsöffnungen (16) nicht von einem Sensorelement überdeckt werden und die beiden äußeren Sensorelemente (20) mit einem Sensorelementüberstand in Erstreckungsrichtung der mittleren Reihe über diese überstehen und an der Unterseite der Bedienfläche (10) anliegen.

8. Bedieneinrichtung nach Anspruch 6 oder 7, **dadurch gekennzeichnet, dass** die Sensorelemente (20, 123) manche der Durchgangsöffnungen (16, 116) der mittleren Reihe überdecken, insbesondere jede zweite Durchgangsöffnung, während die Durchgangsöffnungen (14, 114) der beiden äußeren Reihen stets frei bleiben und vorzugsweise die Sensorelemente (20) mit schmalen Stegen zwischen den Durchgangsöffnungen (14) der äußeren Reihen nach außen verlaufen.

9. Bedieneinrichtung nach einem der Ansprüche 6 bis 8, **dadurch gekennzeichnet, dass** die Durchgangsöffnungen (16, 116) der mittleren Reihen deutlich breiter sind als die Durchgangsöffnungen (14, 114) der äußeren beiden Reihen, insbesondere zweimal bis fünfmal so breit, wobei vorzugsweise sämtliche Durchgangsöffnungen (14, 16, 114, 116) aller Reihen gleich lang sind.

10. Bedieneinrichtung nach Anspruch 1, **dadurch gekennzeichnet, dass** die Aufnahmegehäuse (112, 212) aus elektrisch leitfähigem Material, insbesondere Kunststoff, hergestellt sind und mit ihrer Oberseite an der Unterseite der Bedienfläche (10) anliegen, wobei zwischen zwei aneinander anliegenden Aufnahmegehäusen (112, 212) eine trennende Isolierung (129) vorgesehen ist, wobei vorzugsweise die Isolierung (129) eine auf eine Gehäusewand dauerhaft aufgebrachte Isolierschicht aufweist.

11. Bedieneinrichtung nach Anspruch 10, **dadurch gekennzeichnet, dass** drei parallele Reihen von Durchgangsöffnungen (114, 116) vorgesehen sind und dabei zwei äußere Reihen identische Durchgangsöffnungen (114) aufweisen mit einer mittleren Reihe von Durchgangsöffnungen (116) dazwischen, wobei insbesondere in den Durchgangsöffnungen LED (18) odgl. als Anzeigeelemente angeordnet sind.

12. Bedieneinrichtung nach Anspruch 11, **dadurch gekennzeichnet, dass** die Durchgangsöffnungen (116) der mittleren Reihen deutlich breiter sind als die Durchgangsöffnungen (114) der äußeren beiden Reihen, insbesondere zweimal bis fünfmal so breit, wobei vorzugsweise sämtliche Durchgangsöffnungen (114, 116) aller Reihen gleich lang sind.

13. Bedieneinrichtung nach Anspruch 11 oder 12, **dadurch gekennzeichnet, dass** bei einem Aufnahmegehäuse (112, 212) die beiden äußeren Reihen von Durchgangsöffnungen (114) drei Durchgangsöffnungen aufweisen, wobei vorzugsweise die mittlere Reihe weniger Durchgangsöffnungen (116) aufweist.

14. Bedieneinrichtung nach einem der vorhergehenden Ansprüche, **dadurch gekennzeichnet, dass** die Aufnahmegehäuse (12, 112, 212) parallel zur Bedienfläche (10) verlaufen und flach sind, wobei sie insbesondere rechteckig sind mit einer Breite, die eineinhalb mal bis dreimal so groß ist wie ihre Länge, wobei die Aufnahmegehäuse (12, 112, 212) mit ihren längeren Seiten aneinander anliegen.

15. Bedieneinrichtung nach einem der vorhergehenden Ansprüche, **dadurch gekennzeichnet, dass** die Aufnahmegehäuse (12, 112, 212) auf Bauteilträger (27) aufgesetzt sind, wobei die Bauteilträger (27) die Anzeigeelemente (18) tragen und elektrisch kontaktieren und wobei auch die Sensorelemente (20) an dem Bauteilträger elektrisch kontaktiert sind, insbesondere mit seitlich über die Aufnahmegehäuse (12) überstehenden Abschnitten (25).

## Claims

1. An operating device (11, 111) for an electric appliance comprising a plurality of display elements (18), a plurality of operating elements, and a translucent operating surface (10), with the display elements and operating elements disposed below said surface, for operation by applying a finger and/or by drawing an applied finger across, wherein the operating elements are flat capacitive sensor elements (20, 123) and together with the display elements (18) have common accommodation housings (12, 112, 212), the sensor elements provided on the top surfaces facing the operating surface, wherein the display elements are arranged in through-holes (14, 16, 114, 116) in the accommodation housings,
**characterized in that** the operating device (11, 111) has at least two different adjacent accommodation housings (12, 112, 212) selected from a group of two similar accommodation housings, wherein the group of similar accommodation housings is defined **in that** in each case exterior on both sides of the accommodation housings (12, 112, 212) small through-holes (14, 114) are provided, and between every two small through-holes (14, 114), there is either a large through-hole (16, 116) or a correspondingly large field (15, 115) provided, which is closed,
wherein an accommodation housing (12, 112, 212) has a plurality of through-holes (14, 16, 114, 116) in and between a grid-type frame, respectively.

2. The operating device according to claim 1, **characterized in that** the sensor elements (20) are components separate from the accommodation housings (12) and made of flat material, in particular sheet metal, produced by fabricating of recesses (21, 22) and bending or deforming, wherein preferably the sensor elements are placed on a top surface of the accommodation housing and pressed on by means of said top surface against the underside of the operating surface (10).

3. The operating device according to claim 1 or 2, **characterized in that** the sensor elements (20) are projecting at least on one side, preferably on two opposite sides, beyond an accommodation housing (12) with lateral projections (25) for attachment and/or electric contacting, wherein preferably the lateral projections (25) are bent twice down to an underside of the accommodation housing and a component support (27), respectively, where the accommodation housings are disposed, and protrude laterally therefrom.

4. The operating device according to any one of the preceding claims, **characterized in that** one single sensor element (20, 123) is provided per accommodation housing (12, 112), wherein in particular the sensor element overlaps a smaller surface area than the top surface of the accommodation housing.

5. The operating device according to claim 4, **characterized in that** the sensor element (20) essentially overlaps and covers the accommodation housing (12) with the exception of two or three sensor element cutouts (21) and perforations, respectively, wherein preferably the sensor element (20) towards the sides has in each case only sensor element cutouts (21) and perforations, respectively, that are limited and bordered, respectively, by small webs.

6. The operating device according to any one of the preceding claims, **characterized in that** three parallel rows of through-holes (14, 16, 114, 116) are provided and therein two outer rows have identical through-holes (14, 114) with a central row of through-holes (16, 116) interposed.

7. The operating device according to claim 6, **characterized by** three adjoining accommodation housings (12) with separate sensor elements (20) mounted above, wherein on both ends of the central row the through-holes (16) are not overlapped by a sensor element and the two outer sensor elements (20) project beyond with a sensor element projection in the direction of extension of the central row and rest on the underside of the operating surface (10).

8. The operating device according to claim 6 or 7, **characterized in that** the sensor elements (20, 123) overlap some of the through-holes (16, 116) of the central row, in particular every second through-hole, while the through-holes (14, 114) of the two outer rows always remain free, and preferably, the sensor elements (20) extend outwards with small webs between the through-holes (14) of the outer rows.

9. The operating device according to any one of the claims 6 to 8, **characterized in that** the through-holes (16, 116) of the central rows are significantly wider than the through-holes (14, 114) of the two outer rows, in particular two-fold to five-fold as wide, wherein preferably all the through-holes (14, 16, 114, 116) of all rows are equal in length.

10. The operating device according to claim 1, **characterized in that** the accommodation housings (112, 212) are made of electrically conductive material, in particular synthetic material, and rest with their top against the underside of the operating surface (10), wherein between two adjoining accommodation housings (112, 212) a separating insulation (129) is provided, wherein preferably the insulation (129) includes an insulation layer applied permanently to a housing wall.

11. The operating device according to claim 10, **characterized in that** three parallel rows of through-holes (114, 116) are provided and therein two outer rows have identical through-holes (114) with a central row of through-holes (116) interposed, wherein in particular in the through-holes display elements of LED (18) or the like are disposed.

12. The operating device according to claim 11, **characterized in that** the through-holes (116) of the central rows are significantly wider than the through-holes (114) of the two outer rows, in particular two-fold to five-fold as wide, wherein preferably all the through-holes (114, 116) of all rows are equal in length.

13. The operating device according to claim 11 or 12, **characterized in that** with an accommodation housing (112, 212) the two outer rows of through-holes (114) have three through-holes, wherein preferably the central row has less through-holes (116).

14. The operating device according to any one of the preceding claims, **characterized in that** the accommodation housings (12, 112, 212) extend in parallel to the operating surface (10) and are flat, wherein they are in particular rectangular with a width that is one-and-a-half-fold to three-fold as wide as their length, wherein the accommodation housings (12, 112, 212) rest against another with their longer sides.

15. The operating device according to any one of the preceding claims, **characterized in that** the accommodation housings (12, 112, 212) are placed on component supports (27), wherein the component supports (27) are bearing and electrically contacting the display elements (18), and wherein also the sensor elements (20) are electrically contacting on the component support, in particular with portions (25) laterally projecting beyond the accommodation housings (12).

## Revendications

1. Dispositif de commande (11, 111) pour un appareil électrique, comprenant plusieurs éléments indicateurs (18), plusieurs éléments de commande et une surface de commande (10) transparente à la lumière sous laquelle sont disposés les éléments indicateurs et les éléments de commande pour une commande en appliquant un doigt et/ou en y frottant un doigt appliqué, les éléments de commande étant des éléments de détection (20, 123) capacitifs plats et possédant, conjointement avec les éléments indicateurs (18), des boîtiers d'accueil (12, 112, 212) communs sur les côtés supérieurs desquels se trouvent les éléments de détection orientés vers la surface de commande, les éléments indicateurs étant disposés dans des ouvertures de passage (14, 16, 114, 116) dans les boîtiers d'accueil,
**caractérisé en ce que** le dispositif de commande (11, 111) possède au moins deux boîtiers d'accueil (12, 112, 212) différents juxtaposés, lesquels sont choisis à partir d'un groupe de deux boîtiers d'accueil similaires, le groupe de boîtiers d'accueil similaires étant défini **en ce que** des petites ouvertures de passage (14, 114) se trouvent respectivement à l'extérieur sur les deux côtés du boîtier d'accueil (12, 112, 212), et entre deux petites ouvertures de passage (14, 114) respectives se trouve soit une grande ouverture de passage (16, 116), soit un panneau (15, 115) de taille correspondante qui est fermé,
un boîtier d'accueil (12, 112, 212) possédant plusieurs ouvertures de passage (14, 16, 114, 116) dans ou entre un cadre de type en grille.

2. Dispositif de commande selon la revendication 1, **caractérisé en ce que** les éléments de détection (20) sont des pièces séparées des boîtiers d'accueil (12) et sont fabriqués à partir d'un matériau plat, notamment une tôle métallique par production d'évidements (21, 22) et pliage ou façonnage, les éléments de détection étant de préférence déposés sur un côté supérieur du boîtier d'accueil et étant poussés au moyen de celui-ci contre le côté inférieur de la surface de commande (10).

3. Dispositif de commande selon la revendication 1 ou 2, **caractérisé en ce que** les éléments de détection (20) font saillie sur au moins un côté, de préférence sur deux côtés opposés, au-dessus d'un boîtier d'accueil (12) avec des projections latérales (25) destinées au maintien et/ou à l'établissement d'un contact électrique, les projections latérales (25) étant de préférence pliées deux fois jusqu'au niveau d'un côté inférieur du boîtier d'accueil ou au niveau d'un support de composant (27) sur lequel est disposé le boîtier d'accueil, et dépassent latéralement de celui-ci.

4. Dispositif de commande selon l'une des revendications précédentes, **caractérisé en ce qu'**il n'existe qu'un seul élément de détection (20, 123) par boîtier d'accueil (12, 112), l'élément de détection recouvrant notamment une surface plus petite que le côté supérieur du boîtier d'accueil.

5. Dispositif de commande selon la revendication 4, **caractérisé en ce que** l'élément de détection (20) recouvre et couvre sensiblement le boîtier d'accueil (12) à l'exception de deux ou trois découpes d'élément de détection (21) ou percées, l'élément de détection (20) ne possédant de préférence vers les côtés à chaque fois que des découpes d'élément de détection (21) ou des percées qui sont délimitées ou encadrées par de petites nervures.

6. Dispositif de commande selon l'une des revendications précédentes, **caractérisé en ce qu'**il existe trois rangées parallèles d'ouvertures de passage (14, 16, 114, 116) et deux rangées externes possèdent ici des ouvertures de passage (14, 114) identiques avec une rangée centrale d'ouvertures de passage (16, 116) entre elles.

7. Dispositif de commande selon la revendication 6, **caractérisé par** trois boîtiers d'accueil (12) juxtaposés sur lesquels sont montés des éléments de détection (20) séparés, les ouvertures de passage (16) n'étant pas recouvertes par un élément de détection aux deux extrémités de la rangée centrale et les deux éléments de détection (20) externes dépassant de la rangée centrale avec une saillie d'élément de détection dans le sens de l'extension de celle-ci et reposant contre le côté inférieur de la surface de commande (10).

8. Dispositif de commande selon la revendication 6 ou 7, **caractérisé en ce que** les éléments de détection (20, 123) recouvrent certaines des ouvertures de passage (16, 116) de la rangée centrale, notamment chaque deuxième ouverture de passage, alors que les ouvertures de passage (14, 114) des deux rangées externes restent toujours libres et les éléments de détection (20) munis de nervures étroites s'étendent de préférence vers l'extérieur entre les ouvertures de passage (14) des rangées externes.

9. Dispositif de commande selon l'une des revendications 6 à 8, **caractérisé en ce que** les ouvertures de passage (16, 116) de la rangée centrale sont nettement plus larges que les ouvertures de passage (14, 114) des deux rangées externes, notamment de deux à cinq fois plus larges, toutes les ouvertures de passage (14, 16, 114, 116) de toutes les rangées ayant de préférence la même longueur.

10. Dispositif de commande selon la revendication 1, **caractérisé en ce que** le boîtier d'accueil (112, 212) est fabriqué en un matériau électriquement conducteur, notamment une matière plastique, et repose avec son côté supérieur contre le côté inférieur de la surface de commande (10), une isolation (129) de séparation se trouvant entre deux boîtiers d'accueil (112, 212) juxtaposés, l'isolation (129) possédant de préférence une couche isolante appliquée à demeure sur une paroi de boîtier.

11. Dispositif de commande selon la revendication 10, **caractérisé en ce qu'**il existe trois rangées parallèles d'ouvertures de passage (114, 116) et deux rangées externes possèdent ici des ouvertures de passage (114) identiques avec une rangée centrale d'ouvertures de passage (116) entre elles, des LED (18) ou similaires étant notamment disposées dans les ouvertures de passage en tant qu'éléments indicateurs.

12. Dispositif de commande selon la revendication 11, **caractérisé en ce que** les ouvertures de passage (116) des rangées centrales sont nettement plus larges que les ouvertures de passage (114) des deux rangées externes, notamment de deux à cinq fois plus larges, toutes les ouvertures de passage (114, 116) de toutes les rangées ayant de préférence la même longueur.

13. Dispositif de commande selon la revendication 11 ou 12, **caractérisé en ce que** sur un boîtier d'accueil (112, 212), les deux rangées externes d'ouvertures de passage (114) possèdent trois ouvertures de passage, la rangée centrale possédant de préférence moins d'ouvertures de passage (116).

14. Dispositif de commande selon l'une des revendications précédentes, **caractérisé en ce que** les boîtiers d'accueil (12, 112, 212) s'étendent parallèlement à la surface de commande (10) et sont plats, ceux-ci étant notamment parallélépipédiques avec une largeur qui est d'une fois et demi à trois fois plus grande que leur longueur, les boîtiers d'accueil (12, 112, 212) étant juxtaposés par leurs côtés longs.

15. Dispositif de commande selon l'une des revendications précédentes, **caractérisé en ce que** les boîtiers d'accueil (12, 112, 212) sont posés sur des supports de composant (27), les supports de composant (27) supportant les éléments indicateurs (18) et établissant un contact électrique avec eux, et les éléments de détection (20) établissant également un contact électrique au niveau des supports de composant, notamment avec des portions (25) qui font saillie latéralement au-dessus du boîtier d'accueil (12).
